# EUROPEAN PATENT SPECIFICATION

(11) **EP 3 584 351 B1**
(45) Date of publication and mention of the grant of the patent: **03.08.2022**
(21) Application number: 19180315.4
(22) Date of filing: 14.06.2019
(51) Int. Cl.: C23C 14/22, C23C 14/04, C23C 14/12, C23C 14/24, C23C 14/56, C23C 14/26

(54) **SEQUENTIAL MATERIAL SOURCES FOR THERMALLY CHALLENGED OLED MATERIALS**
SEQUENZIELLE MATERIALQUELLEN FÜR WÄRMEBEANSPRUCHTE OLED-MATERIALIEN
SOURCES SÉQUENTIELLES DE MATÉRIAUX POUR LES MATÉRIAUX DE DIODE ÉLECTROLUMINESCENTE ORGANIQUE SOUMIS À DES CONTRAINTES THERMIQUES

(30) Priority: 18.06.2018 US 201862686110 P; 03.06.2019 US 201916429745
(43) Date of publication of application: 25.12.2019
(73) Proprietor: Universal Display Corporation, Ewing, NJ 08618 (US)
(72) Inventor: QUINN, William E., Ewing, NJ New Jersey 08618 (US); BROWN, Julia, J., Ewing, NJ New Jersey 08618 (US); MCGRAW, Gregory, Ewing, NJ New Jersey 08618 (US); KOTTAS, Gregg, Ewing, NJ New Jersey 08618 (US); MAYWEATHER, William T., Ewing, NJ New Jersey 08618 (US)
(74) Representative: Maiwald Patent- und Rechtsanwaltsgesellschaft mbH

(56) References cited:
- WO-A2-2016/197097
- US-A1- 2009 214 779
- US-A1- 2010 097 416
- TAYLOR D M: "Vacuum-thermal-evaporation: the route for roll-to-roll production of large-area organic electronic circuits", SEMICONDUCTOR SCIENCE AND TECHNOLOGY, IOP PUBLISHING LTD, GB, vol. 30, no. 5, 27 April 2015 (2015-04-27) , page 54002, XP020283697, ISSN: 0268-1242, DOI: 10.1088/0268-1242/30/5/054002 [retrieved on 2015-04-27]
- TSUGITA KOHEI ET AL: "Formation of high-purity organic thin films by gas flow deposition and the effect of impurities on device characteristics", DISPLAYS DEVICES, DEMPA PUBLICATIONS, TOKYO, JP, vol. 34, no. 5, 28 August 2013 (2013-08-28), pages 418-422, XP028785131, ISSN: 0141-9382, DOI: 10.1016/J.DISPLA.2013.08.008

## Description

### FIELD

The present invention relates to systems and techniques for fabricating devices such as organic light emitting diodes, and other devices including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

TAYLOR D M: "Vacuum-thermal-evaporation:the route for roll-to-roll production of large-area organic electronic circuits", SEMICONDUCTOR SCIENCE AND TECHNOLOGY, IOP PUBLISHING LTD, GB, vol. 30, no. 5, 27 April 2015 (201 5-04-27), page 54002, is a journal publication. The authors of this paper describe that they begin from a discussion of the materials and geometrical parameters determining transistor performance and draw on results from numerous publications, and make a case for vacuum-evaporation as an enabler of R2R organic circuit production. The authors describe that the potential of the vacuum route is benchmarked against solution approaches and found to be highly competitive, and that for example, evaporated small molecules tend to have higher mobility than printed OSCs. The authors describe that high resolution metal patterning on plastic films is already a low-cost commercial process for high-volume packaging applications, and that similarly, solvent-free flash-evaporation and polymerization of thin films on plastic substrates is also a high-volume commercial process and has been shown capable of producing robust gate dielectrics. The authors describe that reports of basic logic circuit elements produced in a vacuum R2R environment are reviewed and shown to be superior to all-solution printing approaches. Finally, the authors describe that the main issues that need to be resolved in order to fully develop the vacuum route to R2R circuit production are highlighted.

TSUGITA KOHEI ET AL: "Formation of high-purity organic thin films by gas flow deposition and the effect of impurities on device characteristics", DISPLAYS DEVICES, DEMPA PUBLICATIONS, TOKYO, JP, vol. 34, no. 5, 28 August 2013 (2013-08-28), pages 418-422, is a journal publication. The authors describe that a gas flow deposition (GFD) system was developed to manufacture large-scale organic light-emitting diodes (OLEDs). The authors describe that a N,N'-di(1-naphthyt)-N,N'-diphenylbenzidine (o-NPD) thin film with a high purity of 99.97% was obtained using the GFD system, and that the film properties such as morphology, and electrical and optical characteristics were almost the same as those of films made by conventional vacuum thermal evaporation.

WO2016/197097A2 describes solid films and articles having a surface with discrete regions patterned with a deposited low molecular weight organic compound, such as pharmaceutical actives and new chemical entities. The organic compound may be present at ≥ about 99 mass % in the one or more discrete regions and may be crystalline or amorphous. The deposited organic compound may be deposited as a film having high surface area. The deposited organic compound exhibits enhanced solubility and bioavailability, by way of non-limiting example. Methods of organic vapor jet printing deposition method of such a low molecular weight organic compound in an inert gas stream are also described.

US2010/097416A1 describes an organic dry jet printing head and a printing device and method using the same, in which a pattern (thin film) can be formed through the repetitive injection of a high-speed jet by regularly and repeatedly opening and closing an on-off valve in a pattern (thin film) forming region using the on-off valve and a control unit. It is described that the organic dry jet printing head and the printing device and method using the same are advantageous in that processes can be performed at atmospheric pressure, a large-area organic electronic device can be manufactured and high-resolution patterns can be printed, thereby improving productivity and economic efficiency.

US2009/214779A1 relates to an integrated vapor or liquid phase reagent dispensing apparatus having a plurality of vessels and a plurality of carrier or inert gas feed/vapor or liquid phase reagent delivery manifolds, that may be used for continuously dispensing vapor or liquid phase reagents such as precursors for deposition of materials in the manufacture of semiconductor materials and devices.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.

### SUMMARY

An organic vapor jet printing deposition system and a method for operating it according to the invention are defined in the appended claims. According to an embodiment, an organic vapor jet printing (OVJP) deposition system is provided that includes a plurality of source ampules in fluid communication with a source of carrier gas via a control manifold, the control manifold comprising a plurality of valves, each of which controls a fluid connection between the source of carrier gas and at least one of the source ampules; a plurality of heaters, each heater of the plurality of heaters thermally coupled to one of the plurality of source ampules so that the temperature of each source ampule is controllable independently of each other source ampule via the heater thermally coupled to the source ampule; a mixing chamber in fluid communication with each of the plurality of source ampules; and an OVJP printhead in fluid communication with the mixing chamber.

In an embodiment, an organic vapor jet printing (OVJP) deposition system is provided that includes a plurality of source ampules in fluid communication with a source of carrier gas via a control manifold, each source ampule of the plurality of source ampules containing a first source material, wherein the control manifold comprising a plurality of valves, each of which controls a fluid connection between the source of carrier gas and at least one of the source ampules; a mixing chamber in fluid communication with each of the plurality of source ampules; and an OVJP printhead in fluid communication with the mixing chamber.

Each source ampule may contain the same material, and may be refillable and/or removably connected to the control manifold such that the source ampule is replaceable in the system while the system is in operation. The control manifold may allow gas flow sequentially through each of the source ampules. One or more additional source ampules, distinct from the plurality of source ampules, may be used, in which case the control manifold may allow gas flow sequentially through either the initial source ampules or the additional source ampules. The carrier gas chamber and the control manifold may be external to a deposition chamber in which the source ampules are disposed. Some or all of the source ampules may be connected to the mixing chamber via a single transfer line. The manifold may allow transfer of gas from the carrier gas source to exactly one of the first plurality of source ampules at a time. Each source ampule may contain the same source material. The system also may contain additional source ampules, which may contain the same or different material than the plurality of source ampules. A purge gas source may be in fluid communication with one or more of the source ampules via a dedicated gas line. A balancing manifold may be used to balance pressure and/or flow in the system The control manifold and other components may be configured to automatically direct gas through at least one of the plurality of source ampules at a time, to heat components of the system as appropriate, and otherwise to automatically engage source ampules for use sequentially in the system.

In an embodiment, a method of operating an OVJP deposition system having a plurality of source ampules in fluid communication with a carrier gas source and a mixing chamber, is provided. The method may include heating a first source ampule of the plurality of source ampules to a deposition temperature, the first source ampule containing a first source material; depositing the first source material via the mixing chamber and an OVJP nozzle; subsequent to depositing at least a portion of the first material; heating a second source ampule of the plurality of source ampules to a deposition temperature; closing a valve between the first source ampule and the mixing chamber; opening a valve between the second source ampule and the mixing chamber; and depositing the second material via the mixing chamber and the OVJP nozzle. The first and second material may comprise the same material. The method further may include isolating one or more source ampules of the plurality of source ampules from the deposition chamber and other ampules using one or more valves; and purging and evacuating the one or more source ampules of process gas while the one or more source ampules is isolated from the deposition chamber and the other ampules. The method further may include heating at least a portion of each valve that is in fluid communication with the first source ampule to at least the same temperature as the first source ampule.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows a conventional OVJP deposition system.
FIG. 4A shows a process flow diagram of a conventional OVJP deposition system including host and dopant sources.
FIG. 4B shows a plot of dopant concentration and growth rate as a function of deposition flow fraction of the total flow in a conventional OVJP deposition system.
FIG. 5 shows an example process flow diagram of an embodiment disclosed herein, in which a jet head is fed a species of organic vapor by a battery of individual sources connected to it in parallel that may be heated and discharged sequentially.
FIG. 6 shows an example process flow diagram of an embodiment disclosed herein, which includes shutoff valves downstream of each of the individual sources in the battery.
FIG. 7 shows an example process flow diagram of an embodiment disclosed herein, which includes a source with a downstream shutoff valve connected in parallel with a battery of source ampules, which may be filled with a different source material than the sources in the battery.
FIG. 8 shows an example process flow diagram of an embodiment disclosed herein, which includes a pressure/flow balancer.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

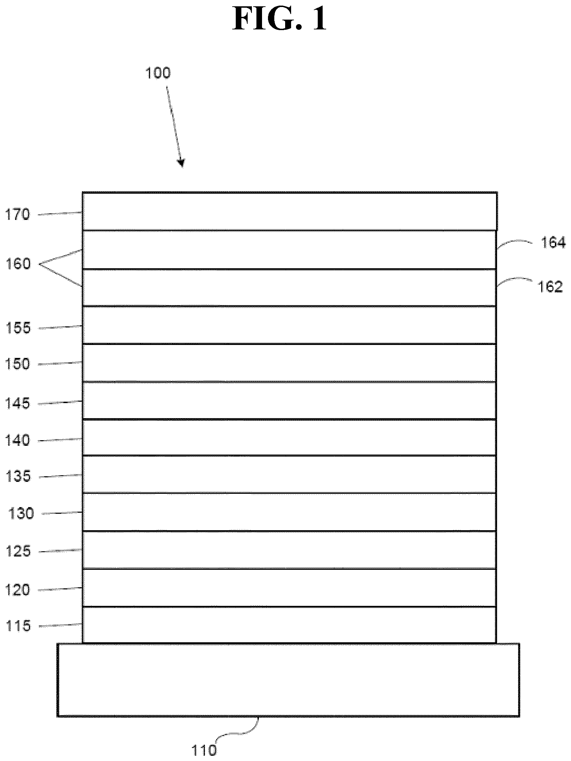

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

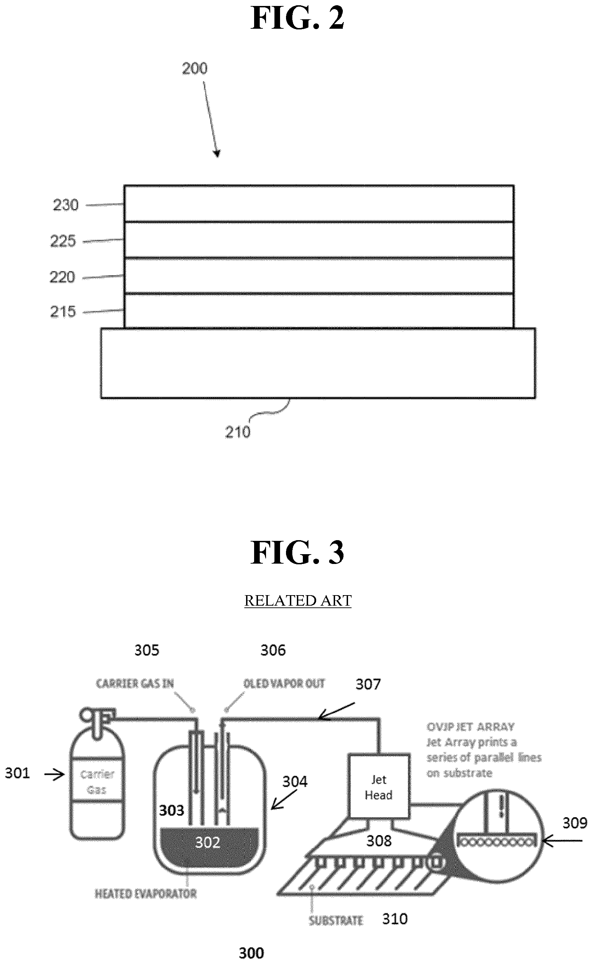

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments of the emissive region, the emissive region further comprises a host.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

As previously disclosed, various systems and techniques are used to fabricate OLEDs and other similar devices. For example, OVJP as previously disclosed is a mask-less, solvent-less printing technique for large area OLED displays. Generally, OLED materials are heated to vaporization temperatures in a source chamber and vapor is transported with a carrier gas to a jet head assembly where the materials condense on a substrate. OVJP techniques and systems are disclosed at least in US Patent Nos. 7,744,957, 7,897,210, 7,879,401, 8,293,329, 8,535,759, 8,574,934, 8,613,496, 8,728,858, 8,801,856, 8,931,431, 8,944,309, 8,939,555, 9,178,184, 9,583,707, 9,653,709, 9,700,901, 9,873,939, 8,940,568 and 9,252,397 and U.S. Publication Nos. 2011/0097495, 2013/0273239, 2015/0376787, 2015/0380648, 2017/0101711, 2017/0104159, and 2017/0306486. In conventional OVJP techniques, vapor streams from multiple sources are mixed before being jetted onto the substrate. The source or sources operate simultaneously, not sequentially, and host-dopant ratios can be changed over a limited range by altering gas flow ratios through two separate sources. The systems are batch type systems in which the sources are operated to exhaustion, and the chamber is vented to re-fill the sources. Conventional OLED display manufacturing techniques often use linear evaporation sources and fine metal shadow masks to define individual pixels. In such a system, linear evaporation sources heat OLED materials to a temperature sufficient to evaporate material with a high flux to rapidly deposit the desired thickness. Large quantities of OLED material are loaded into the evaporation sources to extend the duration of a deposition campaign. However, some OLED source materials may begin to decompose and thereby compromise the quality of the deposited material when exposed to high temperatures for extended periods of time (e.g. during long deposition campaigns).

To address these issues, it has been discovered that the architecture of an OVJP system may be used to prevent or reduce long term thermal degradation of OLED materials if OVJP sources can be operated sequentially. By heating a small portion of the OLED material and consuming it before degradation becomes an issue, thermal degradation may be reduced or entirely avoided. Furthermore, the use of multiple OLED sources that can be used sequentially may enable long deposition campaigns and, more specifically, much longer deposition campaigns than would be desirable or possible using conventional techniques. The present disclosure describes systems and techniques for OVJP deposition which use sequentially heated OLED sources to prevent thermal degradation of OLED materials and enable long campaigns.

FIG. 3 shows a conventional OVJP system. In this system 300, OLED material 302 is contained in a heated, sealed enclosure 304 which contains a gas inlet 305 and gas outlet 306. The organic material is heated to vaporization temperature to form a vapor of OLED material 303 in the headspace of the enclosure. An inert carrier gas 301 flows through the heated enclosure and becomes saturated with organic material. The material is transported to the jet head engine 308 through a heated delivery line 307. The jet head engine contains a series of printing apertures 309 which print OLED material onto a moving substrate 310.

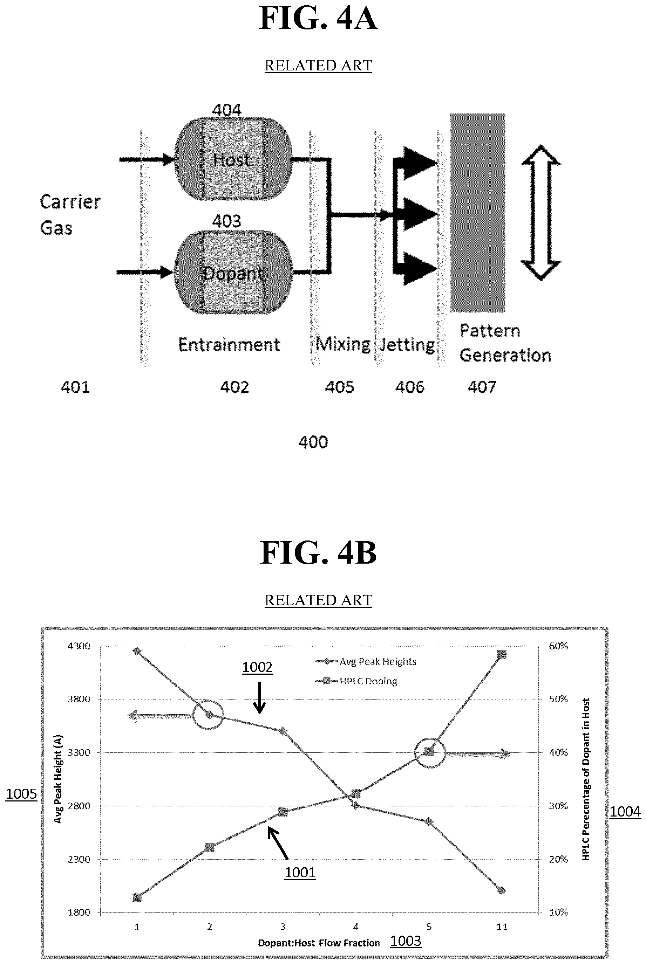

The emissive layers of an OLED device typically include two or more components, a carrier transporting host and the light emitting dopant or dopants. FIG.4A shows a schematic illustration of components typically used to print host and dopant materials by OVJP. Similar to the system 300 shown in FIG. 3, in the system 400 a carrier gas 401 flows through heated, sealed organic containing enclosures, typically referred to as material sources. The carrier gas becomes saturated with organic vapor and the gas streams from the host source 403 and dopant source 404 are mixed at 405, such as in a mixing chamber or equivalent component, before entering a jet head at 406. Organic flux from the source is modulated by changing the source temperature and carrier gas flow. Sources may have a relatively large thermal mass, and the temperature cannot be changed quickly, so temperature is adjusted to get the desired flux at a certain gas flow. The overall gas flow to be used may be determined by the requirements of the specific jet head used in the system 400. The ratio of dopant to host in the printed film can be changed by altering the ratio of gas flows through the dopant and host sources, while keeping the total flow constant.

FIG. 4B shows a plot of dopant concentration 1001 and growth rate 1002 as a function of deposition flow fraction of the total flow in a conventional OVJP system, which is plotted on the horizontal axis 1003, for a fixed host and dopant source temperature. The total carrier gas flow is 12 sccm. The dopant concentration is plotted in volume percent on the right vertical axis 1004 and feature thickness is plotted in Angstroms on the left vertical axis 1005. Typically, the fraction of dopant in the deposited film ranges from 10% to 60% for a gas flow fraction of 8% to 92%. Gas flow modulation works well for composition changes in the mid-range of compositions (5% to 95%), but typically cannot be used to completely shut off organic flux, because the organic material has sufficient vapor pressure to travel from the source to the jet head without a carrier gas. To completely shut off a source, the temperature must be lowered to a point where the vapor pressure is negligible, or a valve must be added between the source and before the gas streams are mixed.

In mass production systems, it typically is desirable to have process equipment producing product as much as possible, i.e., with as few stoppages and breaks in production as possible. This factor of production equipment is termed uptime. Typical semiconductor process equipment operates with uptimes of greater than 85%. OLED displays are currently manufactured using conventional vacuum thermal evaporation sources and shadow masks (fine metal masks). Evaporation sources are large linear sources that are loaded with material and heated to evaporation temperature until the material is exhausted. Evaporation takes place at high vacuum (approximately 10-7 Torr) where the mean free path of ambient gas molecules is much greater than the distance between the source and substrate. Evaporated material travels from the source to the substrate through the gap between the source and substrate; evaporated material condenses on all surfaces in the chamber. The evaporation system must be vented to load another batch of material into the source. To achieve the desired level of uptime, batch deposition systems must be loaded with large amounts of OLED material to extend the time between source material reloads. Unfortunately, some OLED materials begin to degrade after being held at deposition temperature for long periods of time. The degradation products can reduce the performance of deposited films. To maintain high device performance, the amount of source material that can be loaded must be reduced, which shortens the time between source reloads. Using smaller source loads generally reduces uptime and increases production cost. Furthermore, reloading a source within a vacuum chamber may require an extended soak time to return it to high vacuum before growths can resume.

In contrast to conventional systems, embodiments disclosed herein use multiple material sources that are remote from the jet head. Multiple sources may be loaded with small amounts of a material to be deposited and may be used sequentially and therefore heated only when in use. This may minimize or eliminate thermal degradation and provide for large total amounts of material to be loaded into the deposition system. It also may be particularly suited for thermally unstable materials or other materials that may be particularly susceptible to thermal degradation.

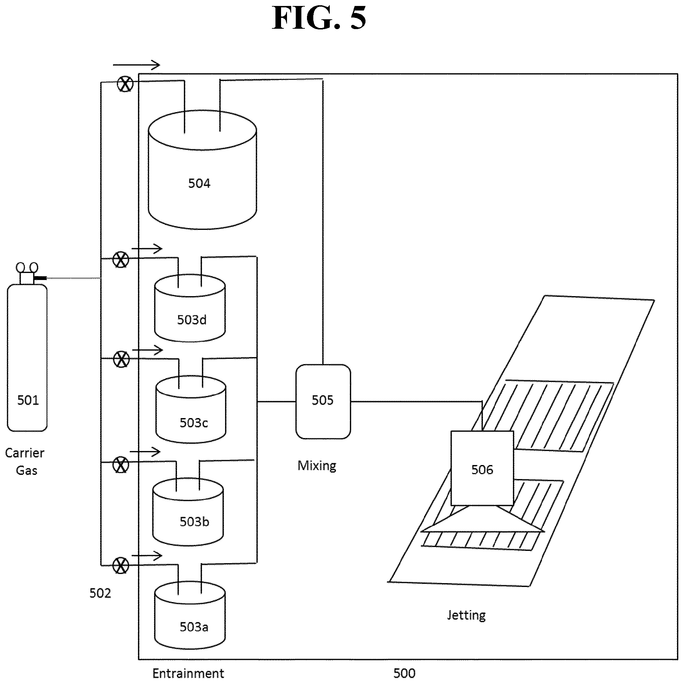

FIG. 5 shows a schematic illustration of such a system according to an embodiment disclosed herein. The system may include multiple source ampules 503a-503d and 504, which are in fluid communication with a source of carrier gas 501. The carrier gas 501, such as H₂, He, Ar or similar, may be connected to a gas control manifold 502 which contains valves and flow controllers to modulate flow to each source ampule 503, 504. That is, each valve in the control manifold 502 may control a fluid connection between the carrier gas source 501 and one or more of the source ampules 503, 504. The carrier gas and control manifold may be external to the deposition chamber 500. Some or all of the sources 503, 504, the mixing chamber or other volume 505, and the jet head 506 may be disposed within a common deposition chamber 500. Materials to be deposited by the jet system, which may include thermally fragile materials, may be loaded into multiple source ampules 503a, 503b, 503c, 503d. In some arrangements, a more thermally robust material may be loaded into a larger source ampule 504. For example, some organic emissive materials may be more resistant to thermal degradation than others, in which case a larger source ampule 504 may be used without causing undesirable degradation of that material while still obtaining the benefit of using a larger amount of the source material than may be used for more thermally sensitive or fragile materials.

The source ampules 503a-503d and 504 may each include, or be thermally coupled to a heater, such that the temperature of each source ampule may be controlled independently of each other source ampule. For example, each source ampule 503a-503d may be thermally coupled to an individual heater that can be used to set the temperature of that source ampule without changing the temperature of the other source ampules. As descried in further detail herein, such an arrangement may allow for each source ampule to be turned "on" or "off," i.e., heated to a deposition temperature and placed in fluid communication with the source of carrier gas, such that the source ampule provides source material to the jet head 506.

At the start of a deposition campaign, the sources 503a and 504 may be heated to deposition temperature and valves supplying carrier gas to those sources may be opened to supply jet head 506 with material to be deposited on the substrate. The jet head 506 may be, for example, an OVJP printhead. The control manifold may allow gas flow sequentially through each of the small source ampules 503a, 503b, 503c, 503d. When the first small source 503a nears completion, the second source 503b may be heated to the deposition temperature, the carrier gas supply valve to 503a may be closed, and a supply valve to the next source 503b may be opened. Once the first source 503a is no longer in use, it may be actively cooled or allowed to cool to ambient temperature. Similarly, when source 503b nears completion, source 503c may be heated to deposition temperature, the supply valve to 503b may be closed, and a supply valve to 503c may be opened. Source 503b is then cooled to ambient temperature. This process is repeated for the remainder of the small sources. When all small sources are depleted, the sources are cooled and refilled. Each valve and/or gas line may be thermally coupled to a heater, as previously disclosed with respect to the source ampules, such that the temperature of each valve may be controlled independently of each other valve and each source ampule so as to prevent condensation and other undesirable effects within the system. In some embodiments, one or more valves may be controlled by the same heater that controls the temperature of a source ampule for which the valve controls gas access. Alternatively or in addition, individual heaters may be used for valves, gas lines, or other components of the systems disclosed herein.

By using small sources that are sequentially heated, thermal degradation is minimized. In some cases, the same material may be placed in each small source ampule 503a, 503b, 503c, 503d. This may be particularly advantageous for a source material that is susceptible to thermal degradation as disclosed herein, since each source ampule may not be maintained at the deposition temperature for long enough to cause degradation of the material that ampule before the ampule is shut off and processing switches to the next source ampule. Furthermore, the system may be operated for a longer total period of time since each source ampule may be removed, cleaned, and/or re-filled with the same or a different source material while the other source ampules are in use. The control manifold also may allow gas flow sequentially though additional source ampules such as ampule 504 in addition to each of the small source ampules 503a-503d, sequentially or concurrently with the small source ampules 503. The additional source ampule or ampules 504 may contain the same source material as the ampules 503, or it may contain a different source material.

In some embodiments, multiple batteries of source ampules may be used. For example, a second battery of source ampules similar to 503a-503d may be connected in parallel with the initial battery 503a-503d, such that either series of source ampules may be used to provide source material in the system. That is, multiple sets of source ampules in series may be connected in parallel within the system, such that each battery may be operated so that the source ampules in the battery are operated in series, as described with respect to 503a-503d. For example, when a first battery is exhausted, a second battery may be used while source ampules in the first battery are replenished.

In FIG. 5 and other figures provided herein, source ampules such as 503, 504 may be referred to as individual "sources" or "source ampules." In some embodiments, each source ampule may be removed, cleaned, refilled, and/or replaced in the system without ceasing operation, as disclosed herein. Unless specifically indicated otherwise, it will be understood that a material "source" as described herein may be provided by, or considered equivalent to, a "source ampule" containing the source material.

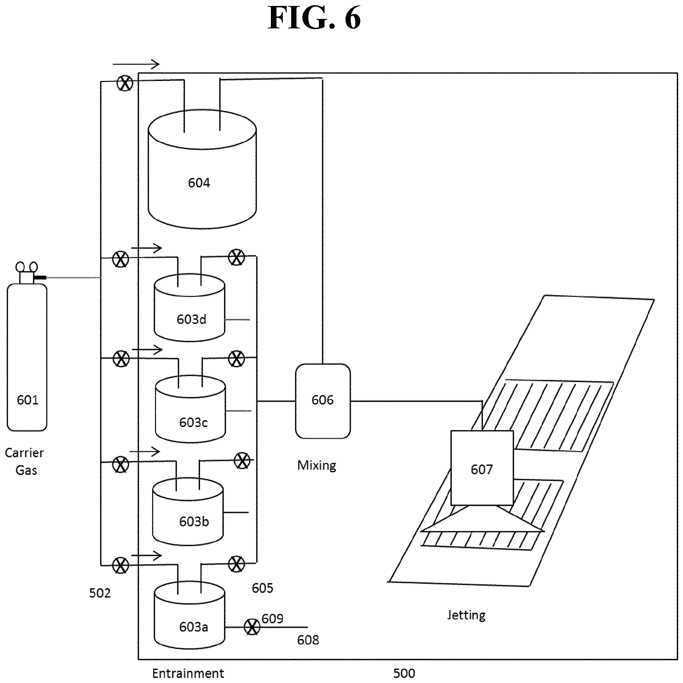

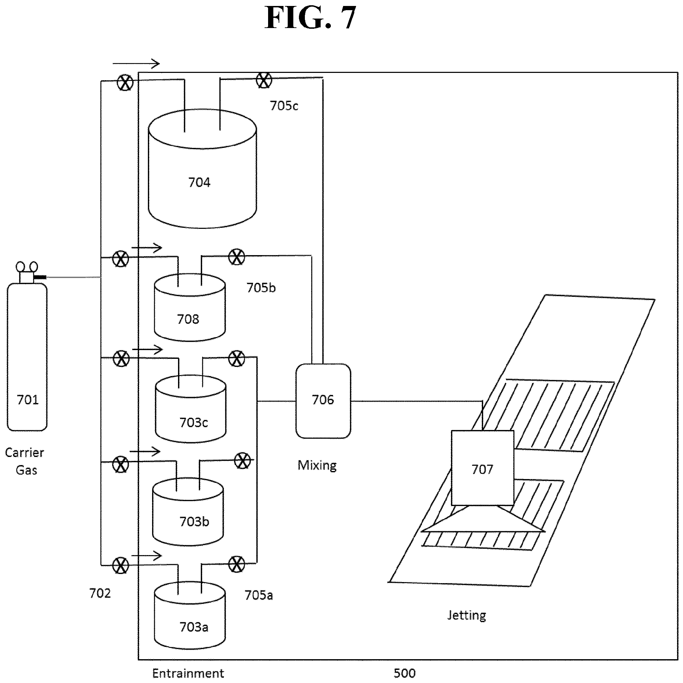

FIG. 6 shows an embodiment as disclosed herein, which incorporates high-temperature values with a sequential-source arrangement as described with respect to FIG.5. Similar to the system described with respect to FIG. 5, multiple source ampules 603a, 603b, 603c, 603d, and 604 may be used. A carrier gas 601 is connected to a gas manifold 502 as previously described. The carrier gas and control manifold may be located external to the deposition chamber 500. Some or all of the sources 603, 604, the mixing chamber or other volume 606, and the jet head 607 may be disposed within the deposition chamber 500. Materials to be deposited by the jet system, which may include thermally fragile materials, may be loaded into the source ampules 603a, 603b, 603c, 603d, and/or a more thermally-robust material may be loaded into the larger source ampule 604 as previously described. Generally the system shown in FIG. 6 may be operated in much the same way as that of FIG. 5, with the additional option to use one or more high temperature valves 605 are disposed between and may be used to control the flow of material between the sources 603a-d, 604 and the mixing volume 606. The use of high temperature valves may be advantageous because the sources 603 have a positive shut-off. In a design that omits such valves after the source, when sources are at the deposition temperature, a small amount of material may leave the source due to the vapor pressure of the organic material. This material then would be transported to the jet head 607 in the absence of a control valve 605 or similar arrangement. The amount of material is small and may not have any deleterious effect on deposited material quality when the sources being switched on and off contain the same material. However, in cases in which the sources contain different materials (an example of which is provided and described with respect to FIG. 7), the possibility of cross-contamination and associated undesirable effects may increase.

Adding positive shut-off valves 605 reduces or minimizes the possibility of cross contamination. If a source is surrounded by isolation valves as shown in FIG. 6 and is external to the deposition chamber, it may be possible to remove, refill, and replace a source ampule without a pause in operation of the deposition tool. Once isolated, the source can be cooled to a safe handling temperature and then serviced or replaced while the rest of the tool remains hot and isolated from the outside environment. The source can then be pump-purged with ultra-pure carrier gas through a dedicated line 608 with its own shut off valve 609 and then brought up to temperature when needed. Other small sources in the source battery 603 can be similarly refilled, permitting the tool to operate indefinitely.

FIG. 7 shows a deposition system as disclosed herein that includes additional source ampules compared to the arrangements shown in FIGS. 5 and 6. The system includes multiple sequential small sources 703a, 703b, 703c, which operate similarly to the sources 503, 603 previously disclosed. The system also includes one small source ampule 708 which may contain a different source material and one larger source ampule 704 containing a third source material, similar to the source ampules 504, 604 as previously disclosed. In this example, all source ampules in the system have positive shut off valves 705, but this may not be required in some embodiments. In general, the system of FIG. 7 operates similarly to those of FIGS. 5 and 6, where carrier gas 701 is transported through one or more of the source ampules 703, 704, 708 to a mixing chamber 706, after which it is deposited by the jet head 707. When operation of the system of FIG. 7 is first started, the source material in source ampules 703a, 704 and 708 may be heated to their respective deposition temperatures, which may be the same or different. Upstream 702 and downstream 705 valves associated with the sources may be opened, in which case the final material deposited by the jet head 707 would include source materials 703a, 704 and 708. By closing upstream valve for source 708 and downstream valve 705b, the deposited material would contain only materials 703b and 704. In this manner both binary material and ternary material mixtures could be deposited using the same system. This method could be extended to more than 3 materials by adding more sources and control valves. Temperature sensitive material 703 may be used in sequentially-heated sources 703a, 703b, and 703c as previously described.

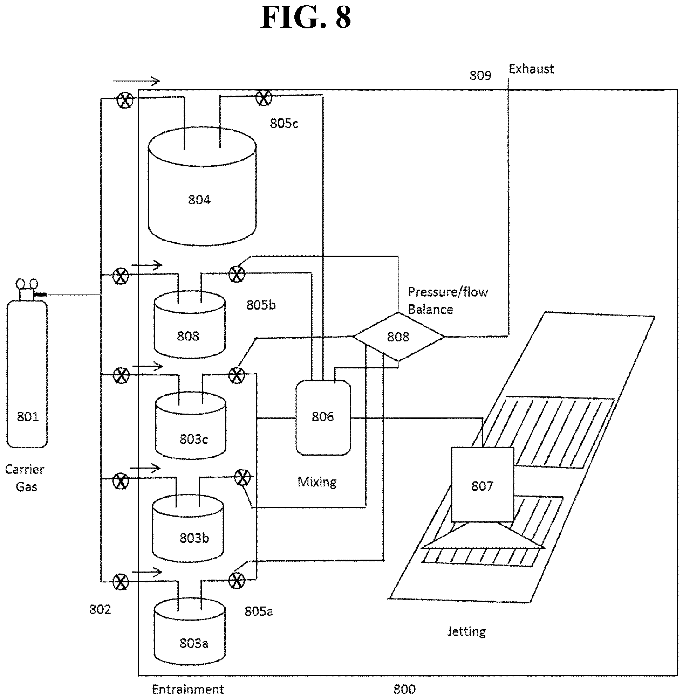

In some embodiments disclosed herein, switching individual source ampules on or off as disclosed herein may produce pressure or flow disruptions at the jet head which may affect the deposition quality. To reduce or minimize the flow and pressure changes when switching sources, a balancing manifold that controls and balances pressure and/or flow within the system may be used. FIG. 8 shows an example of a deposition system according to embodiments disclosed herein in which such a manifold may be used in OVJP. As previously disclosed, a carrier gas 801 may flow through source ampules 803a-803c, 804, and/or 808 to a mixing chamber 806. Source material or materials may be deposited via a jet head 807 as previously disclosed. The downstream valves 805a and 805b (positioned after the source ampules) may be, for example, 3-way valves that switch the flow from the source to either the jet head or a flow and pressure balancing manifold 808. The balancing manifold matches the backpressure and flow of the jet head 807, so that when sources 803, 804, 808 are switched on and off, there is little or no resulting change in the pressure or flow in the mixing volume 806 and/or the jet head 807. To maintain balance, the balancing network may be connected to the carrier gas 801 (to match gas flows), and/or to an exhaust vacuum system 809 (to maintain pressure). The balancing manifold also may add carrier gas to the mixing volume to maintain flow balance.

Unless indicated to the contrary, similar components in FIGS. 5-8 as disclosed herein operate in the same or similar fashion to each other. For example, each jet head 506, 607, 707 807 may be an OVJP printhead, and may operate in similar fashion other than the particular mix of source materials received from the various different source ampules described and shown in each figure. Similarly, each source ampule in each example system shown may include the same or different source material as other source ampules in the same arrangement, depending upon the application used for each system. As another example, each system disclosed herein may include one or more heaters that are thermally coupled to source ampules, valves, gas lines, and other components of the system, in any suitable combination, to allow control of the temperature of each component.

Source ampules as described herein may be removeable, refillable, and/or replaceable within each described system. That is, each source ampule may be removed, refilled, and replaced within the system, or refilled while it is still in place in the system, without ceasing operation of the system as a whole.

In some embodiments, the systems disclosed herein may be configured to operate automatically or semi-automatically. For example, a deposition system as disclosed herein may automatically heat and direct carrier gas through one source ampule out of multiple source ampules containing the same source material at a time, switching from one source ampule to the next automatically as the source material in each source ampule is exhausted. As a specific example, referring to FIG. 8, the deposition system may automatically heat and turn on source ampule 803b by controlling the appropriate valves to allow source material 803b to be deposited, as the source material in an earlier ampule 803a is exhausted. Similarly, the system may automatically turn on source ampule 803c and turn off source ampule 803b as the source material in ampule 803b is exhausted.

It is understood that the various embodiments described herein are by way of example only, and are not intended to limit the scope of the invention.

## Claims

1. An organic vapor jet printing (OVJP) deposition system comprising:
a plurality of source ampules in fluid communication with a source of carrier gas via a control manifold, the control manifold comprising a plurality of valves, each of which controls a fluid connection between the source of carrier gas and at least one of the source ampules;
a plurality of heaters, each heater of the plurality of heaters thermally coupled to one of the plurality of source ampules so that the temperature of each source ampule is controllable independently of each other source ampule via the heater thermally coupled to the source ampule;
a mixing chamber in fluid communication with each of the plurality of source ampules; and
an OVJP printhead in fluid communication with the mixing chamber; and
wherein, the OVJP deposition system is configured to sequentially heat the plurality of source ampules to deposit a material.

2. The deposition system of claim 1, wherein each source ampule is refillable.

3. The deposition system of claim 1, wherein each source ampule is removably connected to the control manifold such that the source ampule is replaceable in the system while the system is in operation.

4. The deposition system of claim 1, wherein the control manifold allows gas flow sequentially through each of the plurality of source ampules.

5. The deposition system of claim 4, further comprising an additional plurality of source ampules distinct from the plurality of source ampules, wherein the control manifold allows gas flow sequentially through either the plurality of source ampules or the additional plurality of source ampules.

6. The deposition system of claim 1, wherein the manifold allows transfer of gas from the carrier gas source to exactly one of the first plurality of source ampules at a time.

7. The deposition system of claim 1, further comprising one or more valves, each of the one or more valves controlling flow of material between one or more of the source ampules and the mixing chamber.

8. The deposition system of claim 7, further comprising a purge gas source in fluid communication with one or more of the source ampules via a dedicated gas line.

9. The deposition system of claim 1, further comprising a balancing manifold in fluid communication with one or more of the source ampules, the carrier gas storage chamber, or both, wherein the balancing manifold is configured to control and balance gas pressure and/or flow.

10. The deposition system of claim 1, wherein the control manifold is configured to automatically direct gas through at least one of the plurality of source ampules at a time, and wherein preferably the system automatically heats and directs carrier gas through exactly one source ampule at a time.

11. A method of operating an OVJP deposition system having a plurality of source ampules in fluid communication with a carrier gas source and a mixing chamber, the method comprising:
heating a first source ampule of the plurality of source ampules to a deposition temperature, the first source ampule containing a first source material;
depositing the first source material via the mixing chamber and an OVJP nozzle;
subsequent to depositing at least a portion of the first material:
heating a second source ampule of the plurality of source ampules to a deposition temperature;
closing a valve between the first source ampule and the mixing chamber;
opening a valve between the second source ampule and the mixing chamber; and
depositing a second material via the mixing chamber and the OVJP nozzle, wherein the first material and second material comprise the same material.

## Patentansprüche

1. Ein organisches Dampfstrahldruck (OVJP) Abscheidungssystem, welches aufweist:
eine Mehrzahl von Quellenampullen, welche in fluider Kommunikation mit einer Quelle von Trägergas mittels eines Steuerverteilers sind, wobei der Steuerverteiler eine Mehrzahl von Ventilen aufweist, von denen jedes eine Fluidverbindung zwischen der Quelle von Trägergas und zumindest einer der Quellenampullen steuert;
eine Mehrzahl von Heizern, wobei jeder Heizer der Mehrzahl von Heizern mit einer der Mehrzahl von Quellenampullen thermisch gekoppelt ist, so dass die Temperatur von jeder Quellenampulle unabhängig von jeder anderen Quellenampulle mittels des mit der Quellenampulle thermisch gekoppelten Heizers steuerbar ist;
eine Mischkammer, welche mit jeder von der Mehrzahl von Quellenampullen in fluider Kommunikation ist; und
einen OVJP-Druckkopf, welcher in fluider Kommunikation mit der Mischkammer ist; und
wobei das OVJP- Abscheidungssystem konfiguriert ist, die Mehrzahl von Quellenampullen sequentiell zu erhitzen, um ein Material abzuscheiden.

2. Das Abscheidungssystem gemäß Anspruch 1, wobei jede Quellenampulle auffüllbar ist.

3. Das Abscheidungssystem gemäß Anspruch 1, wobei jede Quellenampulle mit dem Steuerverteiler lösbar verbunden ist, so dass die Quellenampulle in dem System austauschbar ist, während das System in Betrieb ist.

4. Das Abscheidungssystem gemäß Anspruch 1, wobei der Steuerverteiler Gasfluss sequentiell durch jede der Mehrzahl von Quellenampullen erlaubt.

5. Das Abscheidungssystem gemäß Anspruch 4, ferner aufweisend eine zusätzliche Mehrzahl von Quellenampullen, welche sich von der Mehrzahl von Quellenampullen unterscheiden, wobei der Steuerverteiler Gasfluss sequentiell entweder durch die Mehrzahl von Quellenampullen oder die zusätzliche Mehrzahl von Quellenampullen erlaubt.

6. Das Abscheidungssystem gemäß Anspruch 1, wobei der Verteiler Transfer von Gas von der Trägergasquelle zu genau einer der ersten Mehrzahl von Quellenampullen zu einem Zeitpunkt erlaubt.

7. Das Abscheidungssystem gemäß Anspruch 1, welches ferner ein oder mehrere Ventile aufweist, wobei jedes der ein oder mehreren Ventile Materialfluss zwischen einer oder mehreren der Quellenampullen und der Mischkammer steuert.

8. Das Abscheidungssystem gemäß Anspruch 7, welches ferner eine Spülgasquelle aufweist, welche mittels einer dedizierten Gasleitung mit einer oder mehreren der Quellenampullen in fluider Kommunikation ist.

9. Das Abscheidungssystem gemäß Anspruch 1, welches ferner einen Ausgleichsverteiler aufweist, welcher in fluider Kommunikation mit einer oder mehreren der Quellenampullen, der Trägergas Speicherkammer oder beiden ist, wobei der Ausgleichsverteiler so konfiguriert ist, dass er Gasdruck und/oder -fluss steuert und ausgleicht.

10. Das Abscheidungssystem gemäß Anspruch 1, wobei der Steuerverteiler konfiguriert ist, um automatisch Gas durch zumindest eine von der Mehrzahl von Quellenampullen zu einem Zeitpunkt zu leiten, und
wobei vorzugsweise das System automatisch heizt und das Trägergas durch genau eine Quellenampulle zu einem Zeitpunkt leitet.

11. Verfahren zum Betreiben eines OVJP-Abscheidungssystems, welches eine Mehrzahl von Quellenampullen in fluider Kommunikation mit einer Trägergasquelle und einer Mischkammer hat, wobei das Verfahren aufweist:
Erhitzen einer ersten Quellenampulle von der Mehrzahl von Quellenampullen auf eine Abscheidungstemperatur, wobei die erste Quellenampulle ein erstes Quellenmaterial enthält;
Abscheiden des ersten Quellenmaterials mittels der Mischkammer und einer OVJP-Düse;
Nachfolgend zum Abscheiden zumindest eines Teils des ersten Materials:
Aufheizen einer zweiten Quellenampulle von der Mehrzahl der Quellenampullen auf eine Abscheidungstemperatur;
Schließen eines Ventils zwischen der ersten Quellenampulle und der Mischkammer;
Öffnen eines Ventils zwischen der zweiten Quellenampulle und der Mischkammer;
und
Abscheiden eines zweiten Materials mittels der Mischkammer und der OVJP-Düse, wobei das erste Material und das zweite Material dasselbe Material aufweisen.

## Revendications

1. Système de dépôt par impression de jets de vapeurs organiques (OVJP : organic vapor jet printing) comprenant :
une pluralité d'ampoules sources en communication fluidique avec une source de gaz porteur via un collecteur de commande, le collecteur de commande comprenant une pluralité de vannes, dont chacune commande un raccordement fluidique entre la source de gaz porteur et au moins l'une des ampoules sources ;
une pluralité d'éléments chauffants, chaque élément chauffant de la pluralité d'éléments chauffants étant couplé thermiquement à l'une de la pluralité d'ampoules sources de sorte que la température de chaque ampoule source puisse être commandée indépendamment de chaque autre ampoule source via l'élément chauffant couplé thermiquement à l'ampoule source ;
une chambre de mélange en communication fluidique avec chacune de la pluralité d'ampoules sources ; et
une tête d'impression OVJP en communication fluidique avec la chambre de mélange ; et
dans lequel, le système de dépôt OVJP est configuré pour chauffer séquentiellement la pluralité d'ampoules sources afin de déposer une matière.

2. Système de dépôt selon la revendication 1, dans lequel chaque ampoule source est à remplissages multiples.

3. Système de dépôt selon la revendication 1, dans lequel chaque ampoule source est raccordée de façon amovible au collecteur de commande de sorte que l'ampoule source puisse être remplacée dans le système tandis que le système est en fonctionnement.

4. Système de dépôt selon la revendication 1, dans lequel le collecteur de commande permet un écoulement de gaz séquentiellement à travers chacune de la pluralité d'ampoules sources.

5. Système de dépôt selon la revendication 4, comprenant en outre une pluralité supplémentaire d'ampoules sources distinctes de la pluralité d'ampoules sources, dans lequel le collecteur de commande permet un écoulement de gaz séquentiellement à travers soit la pluralité d'ampoules sources, soit la pluralité supplémentaire d'ampoules sources.

6. Système de dépôt selon la revendication 1, dans lequel le collecteur permet un transfert de gaz depuis la source de gaz porteur vers exactement l'une de la première pluralité d'ampoules sources à la fois.

7. Système de dépôt selon la revendication 1, comprenant en outre une ou plusieurs vannes, chacune des une ou plusieurs vannes commandant un écoulement de matière entre une ou plusieurs des ampoules sources et la chambre de mélange.

8. Système de dépôt selon la revendication 7, comprenant en outre une source de gaz de purge en communication fluidique avec une ou plusieurs des ampoules sources via une conduite de gaz dédiée.

9. Système de dépôt selon la revendication 1, comprenant en outre un collecteur d'équilibrage en communication fluidique avec une ou plusieurs des ampoules sources, la chambre de stockage de gaz porteur, ou les deux, dans lequel le collecteur d'équilibrage est configuré pour commander et équilibrer une pression et/ou un écoulement de gaz.

10. Système de dépôt selon la revendication 1, dans lequel le collecteur de commande est configuré pour diriger automatiquement du gaz à travers au moins l'une de la pluralité d'ampoules sources à la fois, et dans lequel de préférence le système chauffe et dirige automatiquement du gaz porteur à travers exactement une ampoule source à la fois.

11. Procédé de fonctionnement d'un système de dépôt OVJP ayant une pluralité d'ampoules sources en communication fluidique avec une source de gaz porteur et une chambre de mélange, le procédé comprenant :
le chauffage d'une première ampoule source de la pluralité d'ampoules sources jusqu'à une température de dépôt, la première ampoule source contenant une première matière source ;
le dépôt de la première matière source via la chambre de mélange et une buse OVJP ;
suite au dépôt d'au moins une portion de la première matière :
le chauffage d'une seconde ampoule source de la pluralité d'ampoules sources jusqu'à une température de dépôt ;
la fermeture d'une vanne entre la première ampoule source et la chambre de mélange ;
l'ouverture d'une vanne entre la seconde ampoule source et la chambre de mélange ; et
le dépôt d'une seconde matière via la chambre de mélange et la buse OVJP, dans lequel la première matière et la seconde matière comprennent la même matière.
